# EUROPÄISCHE PATENTSCHRIFT

(11) **EP 3 997 741 B1**
(45) Veröffentlichungstag und Bekanntmachung des Hinweises auf die Patenterteilung: **29.03.2023**
(21) Anmeldenummer: 20760910.8
(22) Anmeldetag: 31.07.2020
(51) Int. Cl.: H01L 31/0747, H01L 31/18

(54) **RÜCKSEITENEMITTER-SOLARZELLENSTRUKTUR MIT EINEM HETEROÜBERGANG SOWIE VERFAHREN UND VORRICHTUNG ZUR HERSTELLUNG DERSELBEN**
REAR-EMITTER SOLAR CELL STRUCTURE HAVING A HETEROJUNCTION, AND METHOD AND DEVICE FOR PRODUCING SAME
STRUCTURE DE CELLULE SOLAIRE À ÉMETTEUR ARRIÈRE AYANT UNE HÉTÉROJONCTION, ET PROCÉDÉ ET DISPOSITIF DE PRODUCTION DE CELLE-CI

(30) Priorität: 05.09.2019 DE 102019123785
(43) Veröffentlichungstag der Anmeldung: 18.05.2022
(60) Teilanmeldung: 23156985.6
(73) Patentinhaber: Meyer Burger (Germany) GmbH, 09337 Hohenstein-Ernstthal (DE)
(72) Erfinder: ZHAO, Jun, 2562 Port (CH); KÖNIG, Marcel, 09130 Chemnitz (DE)
(74) Vertreter: Steiniger, Carmen
(86) Internationale Anmeldenummer: PCT/IB2020/057263
(87) Internationale Veröffentlichungsnummer: WO 2021/044232

(56) Entgegenhaltungen:
- EP-A1- 2 682 990
- CN-A- 109 461 780
- JP-A- 2001 044 461
- US-A1- 2017 207 351
- US-A1- 2020 313 019

## Beschreibung

Die vorliegende Erfindung betrifft ein Verfahren zum Herstellen einer Rückseitenemitter-Solarzellenstruktur mit einem Heteroübergang, wobei
- zur Ausbildung eines Absorbers der Rückseitenemitter-Solarzellenstruktur ein kristallines Halbleitersubstrat mit einer Dotierung eines ersten Leitungstyps bereitgestellt wird;
- auf einer Vorderseite des Halbleitersubstrates wenigstens eine Vorderseitenintrinsicschicht aus einem intrinsischen, amorphen Halbleitermaterial erzeugt wird;
- auf der wenigstens einen Vorderseitenintrinsicschicht wenigstens eine Vorderseitendotierschicht aus einem amorphen Halbleitermaterial mit einer Dotierung des ersten Leitungstyps, die höher als die Dotierung des Halbleitersubstrates ist, erzeugt wird;
- auf einer Rückseite des Halbleitersubstrates wenigstens eine Rückseitenintrinsicschicht aus einem intrinsischen, amorphen Halbleitermaterial erzeugt wird;
- zur Ausbildung eines Emitters der Rückseitenemitter-Solarzellenstruktur auf der wenigstens einen Rückseitenintrinsicschicht wenigstens eine Rückseitendotierschicht aus einem amorphen Halbleitermaterial mit einer Dotierung eines zweiten Leitungstyps, der entgegengesetzt zu dem ersten Leitungstyp ist, erzeugt wird;
- auf der wenigstens einen Vorderseitendotierschicht wenigstens eine elektrisch leitfähige, transparente Vorderseitenleitungsschicht erzeugt wird;
- auf der wenigstens einen Rückseitendotierschicht wenigstens eine elektrisch leitfähige, transparente Rückseitenleitungsschicht erzeugt wird;
- auf der wenigstens einen elektrisch leitfähigen, transparenten Vorderseitenleitungsschicht eine Vorderseitenkontaktierung erzeugt wird; und
- auf der wenigstens einen elektrisch leitfähigen, transparenten Rückseitenleitungsschicht eine Rückseitenkontaktierung erzeugt wird.

Die Erfindung betrifft ferner eine Rückseitenemitter-Solarzellenstruktur mit einem Heteroübergang, mit
- einem Absorber aus einem kristallinen Halbleitersubstrat mit einer Dotierung eines ersten Leitungstyps;
- wenigstens einer auf einer Vorderseite des Absorbers ausgebildeten Vorderseitenintrinsicschicht aus einem intrinsischen, amorphen Halbleitermaterial;
- wenigstens einer auf einer Rückseite des Absorbers ausgebildeten Rückseitenintrinsicschicht aus einem intrinsischen, amorphen Halbleitermaterial;
- wenigstens einer auf der wenigstens einen Vorderseitenintrinsicschicht ausgebildeten Vorderseitendotierschicht aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht ausgebildeten Rückseitendotierschicht aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht ausgebildeten elektrisch leitfähigen, transparenten Vorderseitenleitungsschicht;
- wenigstens einer auf der wenigstens einen Rückseitendotierschicht ausgebildeten elektrisch leitfähigen, transparenten Rückseitenleitungsschicht;
- einer auf der wenigstens einen elektrisch leitfähigen, transparenten Vorderseitenleitungsschicht ausgebildeten Vorderseitenkontaktierung, und
- einer auf der wenigstens einen elektrisch leitfähigen, transparenten Rückseitenleitungsschicht ausgebildeten Rückseitenkontaktierung.

Darüber hinaus betrifft die Erfindung eine Vorrichtung zur Herstellung einer Rückseitenemitter-Solarzellenstruktur mit einem Heteroübergang, mit
- einem Absorber aus einem kristallinen Halbleitersubstrat mit einer Dotierung eines ersten Leitungstyps;
- wenigstens einer auf einer Vorderseite des Absorbers ausgebildeten Vorderseitenintrinsicschicht aus einem intrinsischen, amorphen Halbleitermaterial;
- wenigstens einer auf einer Rückseite des Absorbers ausgebildeten Rückseitenintrinsicschicht aus einem intrinsischen, amorphen Halbleitermaterial;
- wenigstens einer auf der wenigstens einen Vorderseitenintrinsicschicht ausgebildeten Vorderseitendotierschicht aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht ausgebildeten Rückseitendotierschicht aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht ausgebildeten elektrisch leitfähigen, transparenten Vorderseitenleitungsschicht;
- wenigstens einer auf der wenigstens einen Rückseitendotierschicht ausgebildeten elektrisch leitfähigen, transparenten Rückseitenleitungsschicht;
- einer auf der wenigstens einen Vorderseitenleitungsschicht ausgebildeten Vorderseitenkontaktierung; und
- einer auf der wenigstens einen Rückseitenleitungsschicht ausgebildeten Rückseitenkontaktierung.

Aus der Druckschrift EP 2 682 990 A1 ist ein Verfahren zum Herstellen einer Solarzelle mit einem Heteroübergang und einem Vorderseitenemitter bekannt. Bei dem bekannten Verfahren wird zunächst auf einer Vorderseite eines eine Dotierung eines ersten Leitungstyps aufweisenden Halbleitersubstrates ein Schichtstapel bestehend aus einer vorderseitigen amorphen intrinsischen Halbleiterschicht und einer vorderseitigen amorphen dotierten Halbleiterschicht abgeschieden. Die vorderseitige amorphe dotierte Halbleiterschicht weist eine Dotierung eines zweiten Leitungstyps auf, der entgegengesetzt zu dem ersten Leitungstyp ist. Danach wird auf der Rückseite des Halbleitersubstrates ein Schichtstapel bestehend aus einer rückseitigen amorphen intrinsischen Halbleiterschicht und einer rückseitigen amorphen dotierten Halbleiterschicht abgeschieden. Die rückseitige amorphe dotierte Halbleiterschicht hat eine Dotierung des gleichen Leitungstyps wie das Halbleitersubstrat.

Daraufhin wird auf der Vorderseite eine transparente, elektrisch leitfähige Schicht als Antireflexionsschicht ohne Strukturierung abgeschieden und danach auf der Rückseite über eine Maske eine elektrisch leitfähige Rückseitenbeschichtung aufgebracht, sodass die elektrisch leitfähige Rückseitenbeschichtung nicht auf den an der Substratkante entstandenen Schichtstapel abgeschieden wird und dadurch keine elektrisch leitfähige Schicht am Substratrand elektrisch kontaktiert. Abschließend werden Vorder- und Rückseitenkontakte erzeugt.

Durch diese Schichtaufbringungsreihenfolge entsteht an der Substratseitenkante eine Schichtabfolge mit alternierender Dotierung, also eine n-p-n⁺- oder eine p-n-p⁺-Abfolge mit jeweils darauf befindlicher Antireflexionsschicht. In der Druckschrift EP 2 682 990 A1 wird darauf hingewiesen, dass die beschriebenen Schichtabscheidungsreihenfolge unbedingt einzuhalten ist, um eine vorteilhafte Kantenisolierung bei der auszubildenden Solarzelle zu erreichen. Insbesondere ist der Vorderseitenschichtstapel, der aus der vorderseitigen amorphen intrinsischen Halbleiterschicht und der vorderseitigen amorphen dotierten Halbleiterschicht besteht, vor dem Rückseitenschichtstapel, der aus der rückseitigen amorphen intrinsischen Halbleiterschicht und der rückseitigen amorphen dotierten Halbleiterschicht besteht, abzuscheiden, um das Risiko des Entstehens von Nebenschlusswiderständen an der Solarzellenkante zu vermeiden.

Die Druckschrift JP 2001044461 A schlägt zur Vermeidung von unerwünschten Solarzellenkantennebenschlüssen an einer einen Heteroübergang aufweisenden Vorderseitenemitter-Solarzellenstruktur vor, zunächst den aus einer rückseitigen amorphen intrinsischen Halbleiterschicht und einer rückseitigen amorphen dotierten Halbleiterschicht bestehenden Schichtstapel nur auf einem Bereich, der kleiner als der Halbeitersubstratbereich ist, also im Abstand vom Substratrand, abzuscheiden. Erst danach soll der aus einer vorderseitigen amorphen intrinsischen Halbleiterschicht und einer vorderseitigen amorphen dotierten Halbleiterschicht bestehende Schichtstapel auf die Substratvorderseite abgeschieden werden.

Eine ähnliche Verfahrensweise ist auch in der Druckschrift US 2017/0207351 A1 beschrieben.

Die vorliegende Erfindung geht im Gegensatz zu dem oben angeführten Stand der Technik von einer Heteroübergang-Solarzellenstruktur mit einem Rückseitenemitter aus. Derartige Solarzellen besitzen gegenüber Heteroübergang-Solarzellen mit Vorderseitenemitter den Vorteil, dass weniger hohe Anforderungen an die optoelektrischen Eigenschaften der elektrisch leitfähigen, transparenten Vorderseitenleitungsschicht und an das Design der Vorderseitenkontaktierung gestellt werden müssen.

Bei solchen Rückseitenemitter-Heteroübergang-Solarzellen ist es im Stand der Technik üblich, zunächst die Abscheidung der intrinsischen Halbleiterschicht und der mit dem gleichen Leitungstyp wie das Halbleitersubstrat dotierten amorphen Halbleiterschicht auf der für einen Lichteinfall vorgesehenen Substratvorderseite vorzunehmen und erst danach die intrinsische Halbleiterschicht und die anders als das Halbleitersubstrat dotierte amorphe Halbleiterschicht auf der Substratrückseite auszubilden.

Es hat sich jedoch gezeigt, dass bei den bekannten Rückseitenemitter-Heteroübergang-Solarzellen Nebenschlusswiderstand und Rückstrom beträchtliche Werte annehmen können, worunter die Solarzellencharakteristik leidet.

Es ist daher die Aufgabe der vorliegenden Erfindung, die elektrischen Solarzelleneigenschaften von Rückseitenemitter-Heteroübergang-Solarzellen zu verbessern.

Diese Aufgabe wird zum einen durch ein Verfahren zum Herstellen einer Rückseitenemitter-Solarzellenstruktur mit einem Heteroübergang gelöst, bei dem
- zur Ausbildung eines Absorbers der Rückseitenemitter-Solarzellenstruktur ein kristallines Halbleitersubstrat mit einer Dotierung eines ersten Leitungstyps bereitgestellt wird;
- auf einer Vorderseite des Halbleitersubstrates wenigstens eine Vorderseitenintrinsicschicht aus einem intrinsischen, amorphen Halbleitermaterial erzeugt wird;
- auf der wenigstens einen Vorderseitenintrinsicschicht wenigstens eine Vorderseitendotierschicht aus einem amorphen Halbleitermaterial mit einer Dotierung des ersten Leitungstyps, die höher als die Dotierung des Halbleitersubstrates ist, erzeugt wird;
- auf einer Rückseite des Halbleitersubstrates wenigstens eine Rückseitenintrinsicschicht aus einem intrinsischen, amorphen Halbleitermaterial erzeugt wird;
- zur Ausbildung eines Emitters der Rückseitenemitter-Solarzellenstruktur auf der wenigstens einen Rückseitenintrinsicschicht wenigstens eine Rückseitendotierschicht aus einem amorphen Halbleitermaterial mit einer Dotierung eines zweiten Leitungstyps, der entgegengesetzt zu dem ersten Leitungstyp ist, erzeugt wird;
- auf der wenigstens einen Vorderseitendotierschicht wenigstens eine elektrisch leitfähige, transparente Vorderseitenleitungsschicht erzeugt wird;
- auf der wenigstens einen Rückseitendotierschicht wenigstens eine elektrisch leitfähige, transparente Rückseitenleitungsschicht erzeugt wird;
- auf der wenigstens einen elektrisch leitfähigen, transparenten Vorderseitenleitungsschicht eine Vorderseitenkontaktierung erzeugt wird; und
- auf der wenigstens einen elektrisch leitfähigen, transparenten Rückseitenleitungsschicht eine Rückseitenkontaktierung erzeugt wird, wobei
   die Vorder- und Rückseitenintrinsicschichten und die Vorder- und Rückseitendotierschichten in folgender Reihenfolge erzeugt werden:
- Erzeugen der wenigstens einen Rückseitenintrinsicschicht auf der Rückseite des Halbleitersubstrates;
- dann Erzeugen der wenigstens einen Vorderseitenintrinsicschicht auf der Vorderseite des Halbleitersubstrates;
- dann Erzeugen der wenigstens einen Vorderseitendotierschicht auf der wenigstens einen Vorderseitenintrinsicschicht; und
- dann Erzeugen der wenigstens einen Rückseitendotierschicht auf der wenigstens einen Rückseitenintrinsicschicht.

Überraschenderweise wird dadurch, dass bei dem erfindungsgemäßen Verfahren erst die intrinsische amorphe Halbleiterschicht auf der Substratrückseite, also die Rückseitenintrinsicschicht, erzeugt wird, dann die intrinsische amorphe Halbleiterschicht und die dotierte amorphe Halbleiterschicht auf der Substratvorderseite und erst danach die amorphe, anders als das Halbleitersubstrat dotierte Halbleiterschicht, also die Vorderseitendotierschicht, auf der Substratvorderseite erzeugt werden, der Nebenschlusswiderstand und der Rückstrom bei allen erfindungsgemäß hergestellten Solarzellen deutlich verbessert. Durch thermografische Messungen ist zudem nachgewiesen, dass der Leckstrom über Substratkanten durch die erfindungsgemäße Verfahrensabfolge stark herabgesetzt wird. Außerdem steigt die Qualität der Passivierung der erfindungsgemäß hergestellten Solarzellen, was sich in einer höheren Leerlaufspannung und einem besseren Füllfaktor der Rückseitenemitter-Heteroübergang-Solarzellen zeigt. Darüber hinaus wird durch das erfindungsgemäße Vorgehen die Solarzelleneffizienz gesteigert.

In einer favorisierten Variante des erfindungsgemäßen Verfahrens wird als Halbleitersubstrat ein n-dotiertes Halbleitersubstrat verwendet, für das Erzeugen der Vorderseitendotierschicht ein mit Phosphor dotiertes amorphes Halbleitermaterial verwendet und zum Erzeugen der Rückseitendotierschicht ein mit Bor dotiertes amorphes Halbleitermaterial verwendet. Da Bor schneller als Phosphor diffundiert und sich daher schneller als Phosphor in der Anlage zur Herstellung der Rückseitenemitter-Solarzellenstruktur mit Heteroübergang verschleppt, wirkt sich die Abscheidung der Bordotierten Rückseitendotierschicht als letzter Schicht bei der Abscheidung der amorphen Schichten besonders positiv auf die Anlagensauberkeit aus.

In einer bevorzugten Ausführungsform des erfindungsgemäßen Verfahrens werden das Erzeugen der wenigstens einen Vorderseitenintrinsicschicht auf der Vorderseite des Halbleitersubstrates und das Erzeugen der wenigstens einen Vorderseitendotierschicht auf der wenigstens einen Vorderseitenintrinsicschicht in direkt nacheinander in ein und demselben Schichtabscheidungsreaktor stattfindenden Prozessen vorgenommen. Man braucht hierdurch für die Herstellung der Vorderseitenintrinsicschicht und der Vorderseitendotierschicht nur einen einzigen Schichtabscheidungsreaktor, was insgesamt die Vorrichtung zur Herstellung der Rückseitenemitter-Solarzellenstruktur mit Heteroübergang vereinfacht und kostengünstiger gestaltet.

Zusätzlich ergibt sich eine besonders guten Kantenisolation der erfindungsgemäß hergestellten Rückseitenemitter-Solarzellenstruktur mit Heteroübergang, wenn die wenigstens eine elektrisch leitfähige, transparente Rückseitenleitungsschicht auf der wenigstens einen Rückseitendotierschicht mit einem Abstand zur Seitenkante des Halbleitersubstrates abgeschieden wird, sodass ein Randbereich auf der Rückseite nicht mit der elektrisch leitfähigen, transparenten Rückseitenleitungsschicht beschichtet ist und bei allen Verfahrensschritten zur Ausbildung der elektrisch leitfähigen, transparenten Rückseitenleitungsschicht kein elektrischer Kontakt zwischen der elektrisch leitfähigen, transparenten Rückseitenleitungsschicht und der Vorderseitenleitungsschicht besteht.

Die Aufgabe wird ferner durch eine Rückseitenemitter-Solarzellenstruktur mit einem Heteroübergang, mit
- einem Absorber aus einem kristallinen Halbleitersubstrat mit einer Dotierung eines ersten Leitungstyps;
- wenigstens einer auf einer Vorderseite des Absorbers ausgebildeten Vorderseitenintrinsicschicht aus einem intrinsischen, amorphen Halbleitermaterial;
- wenigstens einer auf einer Rückseite des Absorbers ausgebildeten Rückseitenintrinsicschicht aus einem intrinsischen, amorphen Halbleitermaterial;
- wenigstens einer auf der wenigstens einen Vorderseitenintrinsicschicht ausgebildeten Vorderseitendotierschicht aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht ausgebildeten Rückseitendotierschicht aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht ausgebildeten elektrisch leitfähigen, transparenten Vorderseitenleitungsschicht;
- wenigstens einer auf der wenigstens einen Rückseitendotierschicht ausgebildeten elektrisch leitfähigen, transparenten Rückseitenleitungsschicht;
- einer auf der wenigstens einen elektrisch leitfähigen, transparenten Vorderseitenleitungsschicht ausgebildeten Vorderseitenkontaktierung, und
- einer auf der wenigstens einen elektrisch leitfähigen, transparenten Rückseitenleitungsschicht ausgebildeten Rückseitenkontaktierung gelöst, wobei
   an einem Seitenrand der Rückseitenemitter-Solarzellenstruktur mit dem Heteroübergang auf einem Randbereich des Halbleitersubstrates eine Schichtfolge in folgender Reihenfolge von innen nach außen vorliegt:
- die wenigstens eine Rückseitenintrinsicschicht,
- darauf die wenigstens eine Vorderseitenintrinsicschicht,
- darauf die wenigstens eine Vorderseitendotierschicht und
- darauf die wenigstens eine Rückseitendotierschicht.

Bedingt durch den Schichtaufbau an dem Seitenrand, also dem Kantenbereich der Rückseitenemitter-Solarzellenstruktur kommt es zu einer deutlichen Verbesserung des Nebenschlusswiderstandes und des Rückstroms der erfindungsgemäß hergestellten Solarzellen im Vergleich zu Rückseitenemitter-Solarzellenstrukturen, welche an ihrem Seitenrand einen konventionellen Schichtaufbau, bei dem von innen nach außen folgende Schichten in folgender Reihenfolge vorliegen bzw. sich in folgender Reihenfolge überlappen:
- die wenigstens eine Vorderseitenintrinsicschicht,
- darauf die wenigstens eine Vorderseitendotierschicht,
- dann die wenigstens eine Rückseitenintrinsicschicht, und
- darauf die wenigstens eine Rückseitendotierschicht.

Bei einer favorisierten Ausführungsfrom der erfindungsgemäßen Rückseitenemitter-Solarzellenstruktur mit Heteroübergang ist das Halbleitersubstrat ein n-dotiertes Halbleitersubstrat, die Vorderseitendotierschicht mit Phosphor dotiert und die Rückseitendotierschicht mit Bor dotiert.

Eine vorteilhafte Ausbildung der erfindungsgemäßen Rückseitenemitter-Solarzellenstruktur mit Heteroübergang ist so aufgebaut, dass die wenigstens eine elektrisch leitfähige, transparente Rückseitenleitungsschicht auf der wenigstens einen Rückseitendotierschicht mit einem Abstand zur Seitenkante des Halbleitersubstrates abgeschieden ist, sodass ein Randbereich auf der Rückseite nicht mit der elektrisch leitfähigen, transparenten Rückseitenleitungsschicht beschichtet ist und kein elektrischer Kontakt zwischen der elektrisch leitfähigen, transparenten Rückseitenleitungsschicht und der Vorderseitenleitungsschicht besteht.

Die Aufgabe wird darüber hinaus durch eine Vorrichtung zur Herstellung einer Rückseitenemitter-Solarzellenstruktur mit einem Heteroübergang, mit
- einem Absorber aus einem kristallinen Halbleitersubstrat mit einer Dotierung eines ersten Leitungstyps;
- wenigstens einer auf einer Vorderseite des Absorbers ausgebildeten Vorderseitenintrinsicschicht aus einem intrinsischen, amorphen Halbleitermaterial;
- wenigstens einer auf einer Rückseite des Absorbers ausgebildeten Rückseitenintrinsicschicht aus einem intrinsischen, amorphen Halbleitermaterial;
- wenigstens einer auf der wenigstens einen Vorderseitenintrinsicschicht ausgebildeten Vorderseitendotierschicht aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht ausgebildeten Rückseitendotierschicht aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht ausgebildeten elektrisch leitfähigen, transparenten Vorderseitenleitungsschicht;
- wenigstens einer auf der wenigstens einen Rückseitendotierschicht ausgebildeten elektrisch leitfähigen, transparenten Rückseitenleitungsschicht;
- einer auf der wenigstens einen Vorderseitenleitungsschicht ausgebildeten Vorderseitenkontaktierung; und
- einer auf der wenigstens einen Rückseitenleitungsschicht ausgebildeten Rückseitenkontaktierung gelöst, wobei
   die Vorrichtung zum Erzeugen der wenigstens einen Vorderseitenintrinsicschicht auf der Vorderseite des Halbleitersubstrates, der wenigstens einen Rückseitenintrinsicschicht auf der Rückseite des Halbleitersubstrates, der wenigstens einen Vorderseitendotierschicht auf der wenigstens einen Vorderseitenintrinsicschicht und der wenigstens einen Rückseitendotierschicht auf der wenigstens einen Rückseitenintrinsicschicht nur drei Schichtabscheidungsstränge aufweist, wobei
- ein erster Schichtabscheidungsstrang wenigstens einen Schichtabscheidungsreaktor zum Erzeugen der wenigstens einen Rückseitenintrinsicschicht auf der Rückseite des Halbleitersubstrates aufweist;
- ein zweiter Schichtabscheidungsstrang wenigstens einen Schichtabscheidungsreaktor zum Erzeugen der wenigstens einen Vorderseitenintrinsicschicht auf der Vorderseite des Halbleitersubstrates und zum Erzeugen der wenigstens einen Vorderseitendotierschicht auf der wenigstens einen Vorderseitenintrinsicschicht aufweist; und
- ein dritter Schichtabscheidungsstrang wenigstens einen Schichtabscheidungsreaktor zum Erzeugen der wenigstens einen Rückseitendotierschicht auf der wenigstens einen Rückseitenintrinsicschicht aufweist;
und wobei zwischen dem ersten und dem zweiten Schichtabscheidungsstrang sowie zwischen dem zweiten und dem dritten Schichtabscheidungsstrang wenigstens ein Substrattransport- und -wendesystem vorgesehen ist.

Im Gegensatz zum Stand der Technik durchläuft in der erfindungsgemäßen Vorrichtung das Halbleitersubstrat erst den ersten Schichtabscheidungsstrang mit dem wenigstens einen Schichtabscheidungsreaktor zum Erzeugen der wenigstens einen Rückseitenintrinsicschicht, wird dann gewendet, erst danach dem zweiten Schichtabscheidungsstrang mit dem wenigstens einen Schichtabscheidungsreaktor zum Erzeugen der wenigstens einen Vorderseitenintrinsicschicht auf der Vorderseite des Halbleitersubstrates und zum Erzeugen der wenigstens einen Vorderseitendotierschicht auf der wenigstens einen Vorderseitenintrinsicschicht zugeführt, danach wieder gewendet und erst zum Schluss in den dritten Schichtabscheidungsstrang mit dem wenigstens einen Schichtabscheidungsreaktor zum Erzeugen der wenigstens einen Rückseitendotierschicht auf der wenigstens einen Rückseitenintrinsicschicht transportiert.

In einer bevorzugten Ausgestaltung der erfindungsgemäßen Vorrichtung weist der erste Schichtabscheidungsstrang einen Rückseitenintrinsicschichtabscheidungsreaktor zum Erzeugen der wenigstens einen Rückseitenintrinsicschicht auf der Rückseite des Halbleitersubstrates auf; weist der zweite Schichtabscheidungsstrang einen einzigen Vorderseitenschichtabscheidungsreaktor zum Erzeugen der wenigstens einen Vorderseitenintrinsicschicht auf der Vorderseite des Halbleitersubstrates und der wenigstens einen Vorderseitendotierschicht auf der wenigstens einen Vorderseitenintrinsicschicht auf; und weist der dritte Schichtabscheidungsstrang einen Rückseitendotierschichtabscheidungsreaktor zum Erzeugen der wenigstens einen Rückseitendotierschicht auf der wenigstens einen Rückseitenintrinsicschicht auf; und ist das wenigstens eine Substrattransport- und -wendesystem vor dem Vorderseitenschichtabscheidungsreaktor vor oder in dem zweiten Schichtabscheidungsstrang vorgesehen.

Bevorzugte Ausführungsformen der vorliegenden Erfindung werden im Folgenden anhand von Figuren näher erläutert, wobei
- die Figuren 1 a bis 1i:: schematisch Teilschritte einer Prozessabfolge einer Ausführungsform des erfindungsgemäßen Verfahrens zur Herstellung einer Rückseitenemitter-Solarzellenstruktur mit Heteroübergang anhand von Querschnittsansichten der jeweils erzeugten Schichtfolge darstellen;
- Figur 2: schematisch einen an einem Seitenrand eines Zwischenproduktes einer erfindungsgemäßen Rückseitenemitter-Solarzellenstruktur mit Heteroübergang ausgebildeten Schichtstapel nach der Ausbildung der intrinsischen und amorphen Halbleiterschichten zeigt;
- Figur 3: schematisch einen möglichen Grundaufbau eines Teilbereichs einer erfindungsgemäßen Vorrichtung zur Herstellung von Rückseitenemitter-Solarzellenstrukturen mit Heteroübergang zeigt; und
- Figur 4: schematisch einen weiteren möglichen Grundaufbau eines Teilbereichs der erfindungsgemäßen Vorrichtung zur Herstellung von Rückseitenemitter-Solarzellenstrukturen mit Heteroübergang zeigt.

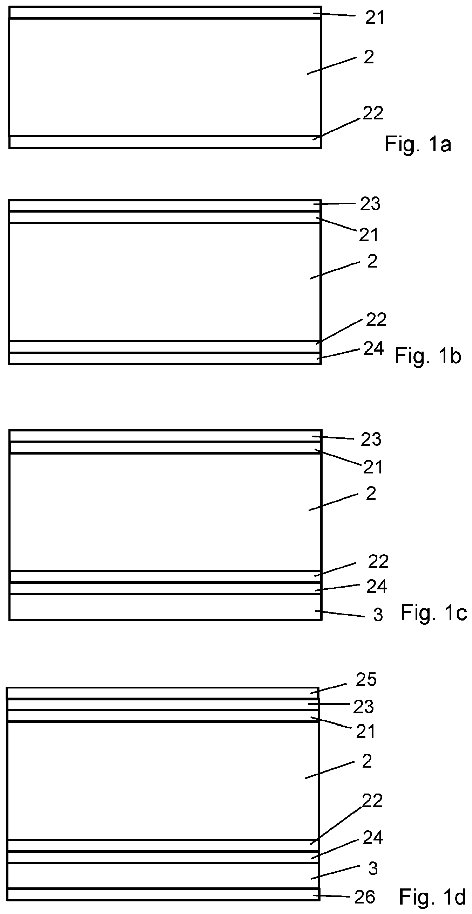

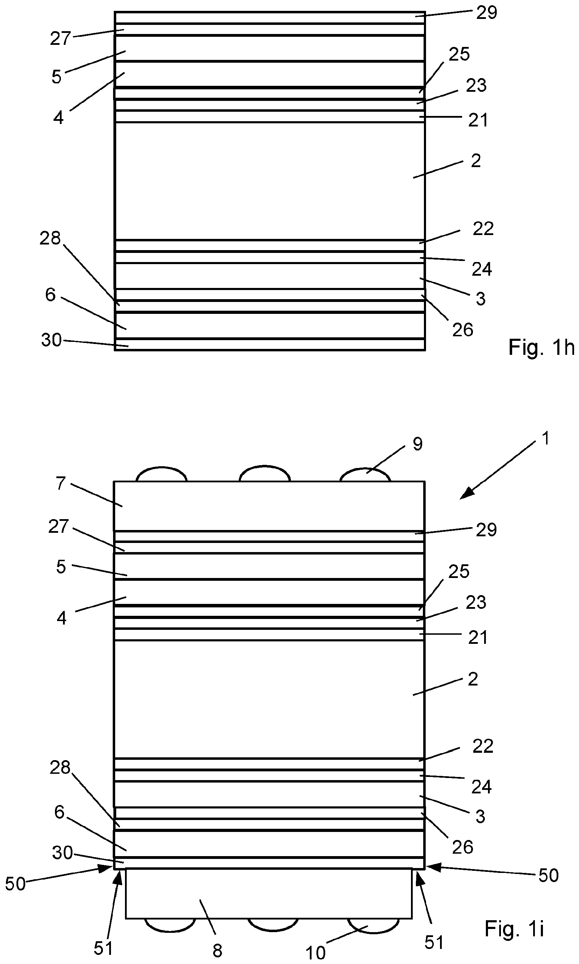

Die Figuren 1a bis 1i zeigen schematisch Teilschritte einer Prozessabfolge einer Ausführungsform des erfindungsgemäßen Verfahrens zur Herstellung einer Rückseitenemitter-Solarzellenstruktur 1 mit Heteroübergang, wie sie beispielsweise in Figur 1i schematisch im Querschnitt gezeigt ist, anhand von Querschnittsansichten der jeweils erzeugten Schichtfolge. Dabei sind die Schichtdicken der in den einzelnen Figuren dargestellten Schichten nicht maßstabsgetreu dargestellt. Zwar ist das Verhältnis der jeweiligen Schichtdicken zueinander ebenfalls nicht maßstabsgetreu dargestellt, jedoch ist dann, wenn eine Schicht dünner als eine andere dargestellt ist, diese auch in der Realität typischerweise dünner.

In den Figuren ist die jeweils oben dargestellte Seite der jeweiligen Schichtstruktur die Vorderseite und die unten dargestellte Seite die Rückseite der jeweiligen Schichtstruktur. Die Vorderseite ist die Seite, in die bei der fertigen Rückseitenemitter-Solarzellenstruktur 1 ein Lichteinfall vorgesehen ist.

Figur 1a zeigt schematisch ein kristallines Halbleitersubstrat 2, auf dessen Vorder- und Rückseite Luftoxidschichten 21, 22 ausgebildet sind. Das Halbleitersubstrat 2 weist eine Dotierung eines ersten Leitungstyps auf. In dem gezeigten Ausführungsbeispiel ist das Halbleitersubstrat 2 ein n-dotiertes Siliziumsubstrat, kann aber in anderen Ausführungsformen der Erfindung auch aus einem anderen Halbleitermaterial ausgebildet sein und/oder eine p-Dotierung aufweisen. Vorzugsweise ist die n-Dotierung eine Phosphor-Dotierung, kann aber auch mit wenigstens einem anderen und/oder wenigstens einem zusätzlichen Dotierstoff ausgebildet sein.

Die Luftoxidschichten 21, 22 sind in dem gezeigten Beispiel SiO₂-Schichten mit einer Dicke zwischen 0,2 und 3,0 nm.

Die Luftoxidschichten 21, 22 bilden sich automatisch an der Atmosphäre auf dem vorher gereinigten Halbleitersubstrat 2. Das Halbeitersubstrat 2 bildet bei der fertigen Rückseitenemitter-Solarzellenstruktur 1 einen Absorber aus.

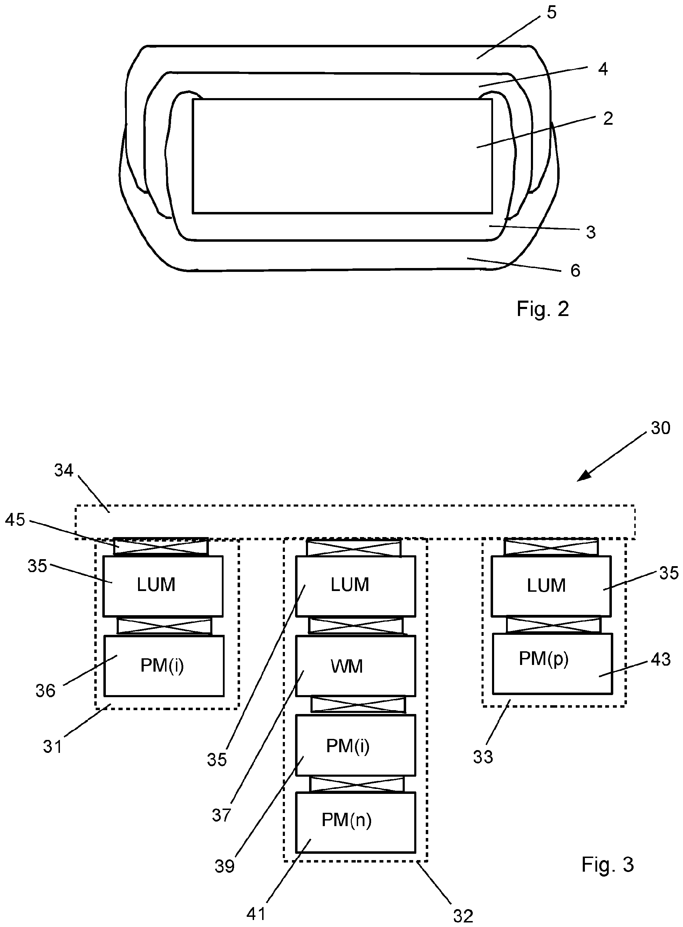

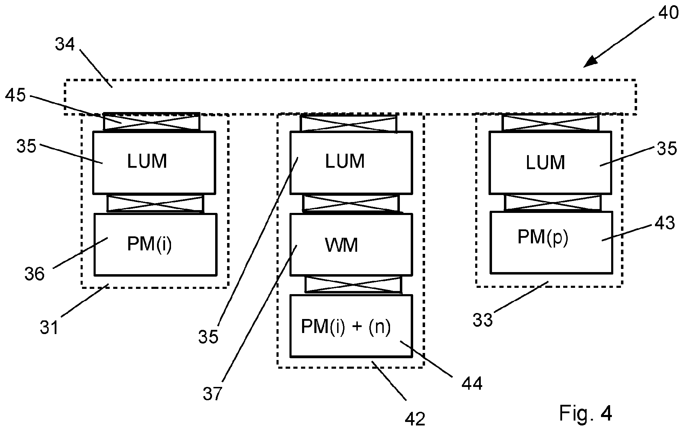

Figur 1b zeigt das Halbleitersubstrat 2 aus Figur 1a nach einem weiteren Verfahrensschritt, in welchem das Halbleitersubstrat 2 in eine Vorrichtung zur Herstellung von Rückseitenemitter-Solarzellenstrukturen 1 mit Heteroübergang geladen wird. Teilbereiche von Beispielen für eine solche Vorrichtungen 30, 40 sind in den Figuren 3 und 4 gezeigt.

Während des Ladens sind beide Seiten des Halbleitersubstrates 2 bei Temperaturen von typischerweise unter 200 °C der Atmosphäre ausgesetzt, sodass sich nochmals Luftoxidschichten 23, 24, also hier SiO₂-Schichten mit einer Dicke von 0,2 bis 3,0 nm, auf der Vorder- und der Rückseite des Halbleitersubstrates 2 ausbilden bzw. die Luftoxidschichten 21, 22 um die Dicke der Luftoxidschichten 23, 24 anwachsen.

In einem weiteren, in Figur 1c schematisch dargestellten Verfahrensschritt des erfindungsgemäßen Verfahrens wird auf die Rückseite des die Luftoxidschichten 21, 22, 23, 24 aufweisenden Halbleitersubstrates 2 wenigstens eine Rückseitenintrinsicschicht 3 aus wenigstens einem intrinsischen, amorphen Halbleitermaterial abgeschieden. Die Abscheidung der wenigstens einen Rückseitenintrinsicschicht 3 erfolgt vorzugsweise mit einem PECVD-Verfahren.

In dem in Figur 1d gezeigten Schritt, indem die Schichtstruktur aus Figur 1c zum nächsten Schichtabscheidungsreaktor transportiert und gewendet wird, bilden sich wiederum Luftoxidschichten 25, 26 auf der Vorder- und der Rückseite der Schichtstruktur aus Figur 1c aus. Die Luftoxidschichten 25, 26 sind in dem gezeigten Beispiel SiO₂-Schichten mit einer Dicke von 0,2 bis 3,0 nm. Die Luftoxidschicht 25 wächst direkt auf den auf der Vorderseite bereits bestehenden Luftoxidschichten 21, 23 auf. Die Luftoxidschicht 26 wächst auf der abgeschiedenen Rückseitenintrinsicschicht 3 auf.

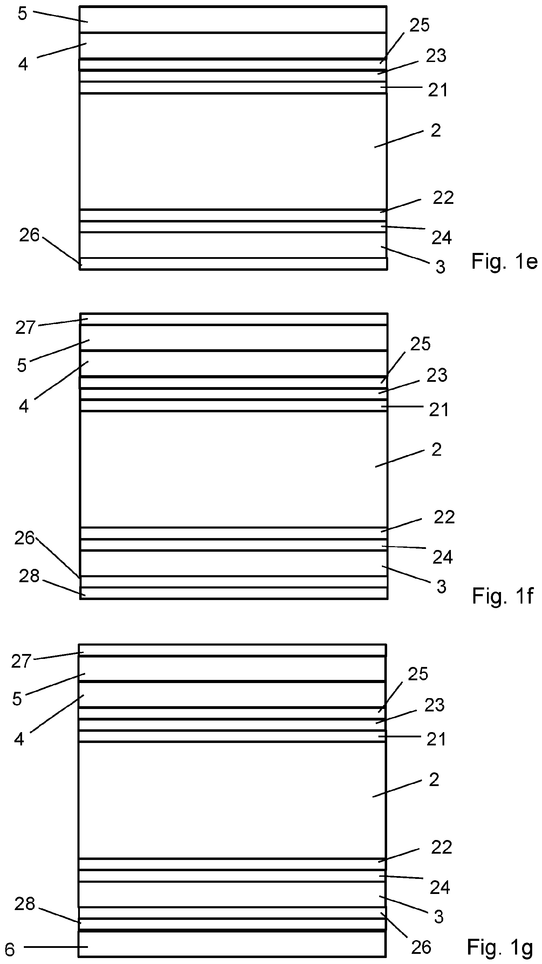

Nach Abscheidung der Rückseitenintrinsicschicht 3 werden auf die Vorderseite des Halbleitersubstrates 2 mit den darauf befindlichen Schichten 21, 23, 25 wenigstens eine Vorderseitenintrinsicschicht 4 aus wenigstens einem amorphen intrinsischen Halbleitermaterial und wenigstens eine Vorderseitendotierschicht 5 aus wenigstens einem amorphen Halbleitermaterial mit einer Dotierung des ersten Leitungstyps, die höher als die Dotierung des Halbleitersubstrates 2 ist, abgeschieden. Dies ist in Figur 1e zu sehen. Da in dem gezeigten Ausführungsbeispiel das Halbleitersubstrat 2 n-dotiert ist, ist hier auch die Vorderseitendotierschicht 5 n-dotiert, vorzugsweise mit Phosphor dotiert.

Die Vorderseitenintrinsicschicht 4 kann separat von der Vorderseitendotierschicht 5, in unterschiedlichen Schichtabscheidungsreaktoren abgeschieden werden. Es ist jedoch besonders von Vorteil, wenn, wie in dem gezeigten Ausführungsbeispiel geschehen, die Vorderseitendotierschicht 5 direkt nach der Vorderseitenintrinsicschicht 4 in ein und demselben Schichtabscheidungsreaktor ohne zwischenzeitliches Substrathandling abgeschieden wird. In diesem Fall wird eine Luftoxidbildung zwischen der Vorderseitenintrinsicschicht 4 und der Vorderseitendotierschicht 5 vermieden.

Bei dem nach dieser Schichtabscheidung bzw. diesen Schichtabscheidungen erforderlichen Substrathandling, während dessen ein Substratransport zum nächsten Schichtabscheidungsreaktor und erneut ein Wenden des Substrates stattfindet, gelangt die erzeugte und in Figur 1e schematisch gezeigte Schichtstruktur erneut an Atmosphäre, wodurch wiederum Luftoxidschichten 27, 28 auf beiden Seiten der Schichtstruktur wachsen, was in Figur 1f gezeigt ist. Die Luftoxidschichten 27, 28 sind in dem Ausführungsbeispiel SiO₂-Schichten mit einer Schichtdicke zwischen 0,2 und 3,0 nm.

Nach einem weiteren Substrathandling wird auf der Rückseite der in Figur 1f gezeigten Schichtanordnung eine Rückseitendotierschicht 6 aus einem amorphen Halbleitermaterial mit einer Dotierung eines zweiten Leitungstyps, der entgegengesetzt zu dem ersten Leitungstyp ist, erzeugt. Dies ist in Figur 1g dargestellt. In dem gezeigten Ausführungsbeispiel ist die Rückseitendotierschicht 6 eine p-dotierte, amorphe Siliziumschicht. Speziell ist die in dem Beispiel verwendete p-Dotierung eine Bor-Dotierung, kann jedoch in anderen Ausführungsbeispielen der Erfindung eine andere Dotierung sein. Die Rückseitendotierschicht 6 bildet der darauf vorgesehenen, im nachfolgenden beschriebenen elektrischen Kontaktierung den Emitter der auszubildenden Rückseitenemitter-Solarzellenstruktur 1 mit Heteroübergang.

Die Schichtstruktur aus Figur 1g wird im Folgenden zu wenigstens einem weiteren Schichtabscheidungsreaktor transportiert, wobei die Schichtstruktur während des Transportes erneut Atmosphärenbedingungen ausgesetzt ist. Dabei bilden sich wiederum etwa 0,2 bis 3,0 nm dünne Luftoxidschichten 29, 30 auf der Vorder- und der Rückseite der Schichtstruktur aus, was in Figur 1h zu sehen ist.

Danach werden, wie es in Figur 1i schematisch dargestellt ist, auf der Vorderseite und der Rückseite der Schichtstruktur aus Figur 1h elektrisch leitfähige, transparente Vorder- und Rückseitenleitungsschichten 7, 8 erzeugt. Die elektrisch leitfähigen, transparenten Vorder- und Rückseitenleitungsschichten 7, 8 bestehen vorzugsweise aus elektrisch leitfähigem, transparenten Oxid (TCO). In dem gezeigten Ausführungsbeispiel sind die elektrisch leitfähigen, transparenten Vorder- und Rückseitenleitungsschichten 7, 8 Indium-Zinn-Oxid-Schichten (ITO-Schichten).

Die elektrisch leitfähige, transparente Rückseitenleitungsschicht 8 ist in dem gezeigten Ausführungsbeispiel auf der wenigstens einen Rückseitendotierschicht 6 mit einem Abstand zur Seitenkante 50 des Halbleitersubstrates 2 abgeschieden. Die Abscheidung der Rückseitendotierschicht 6 kann beispielsweise über eine Maske erfolgen. Dadurch bleibt ein Randbereich 51 auf der Rückseite der Rückseitenemitter-Solarzellenstruktur 1 mit Heteroübergang von der elektrisch leitfähigen, transparenten Rückseitenleitungsschicht 8 unbeschichtet. Durch die strukturierte Abscheidung besteht kein elektrischer Kontakt zwischen der elektrisch leitfähigen, transparenten Rückseitenleitungsschicht 8 und der Vorderseitenleitungsschicht 7, auch nicht während der Abscheidung der elektrisch leitfähigen, transparenten Rückseitenleitungsschicht 8.

Abschließend werden jeweils auf den elektrisch leitfähigen, transparenten Vorder- und Rückseitenleitungsschichten 7, 8 Vorderseiten- bzw. Rückseitenkontaktierungen 9, 10 erzeugt. Die Vorderseiten- und Rückseitenkontaktierungen 9, 10 sind in dem gezeigten Ausführungsbeispiel aus Silber ausgebildet und in Fingerform auf der Solarzellenvorderseite und der Solarzellenrückseite vorgesehen. Sie können jedoch auch aus anderem, elektrisch leitfähigen Material ausgebildet sein und/oder in anderer Form aufgebracht sein.

Wie es den obigen Ausführungen entnehmbar ist, entstehen bei jedem Substrattransport Luftoxidschichten 21, 22, 23, 24, 25, 26, 27, 28, 29, 30, welche Barrieren zwischen dem Halbeitersubstrat 2 und den darauf abgeschiedenen Intrinsicschichten 3, 4, zwischen der Rückseitenintrinsicschicht 4 und der Rückseitendotierschicht 6 sowie zwischen den Vorder- und Rückseitendotierschichten 5, 6 und den jeweils darauf abgeschiedenen Vorder- bzw. Rückseitenleitungsschichten 7, 8 ausbilden. Diese Barrieren behindern den Leitungsträgertransport und verschlechtern damit die Solarzelleneigenschaften der auszubildenden Rückseitenemitter-Solarzellenstruktur 1 mit Heteroübergang. Indem, wie oben beschrieben, die Vorderseitendotierschicht 5 direkt nach der Vorderseitenintrinsicschicht 4 in demselben Schichtabscheidungsreaktor abgeschieden wurde, konnte eine solche Barrierenbildung zwischen der Vorderseitenintrinsicschicht 4 und der Vorderseitendotierschicht 5 vermieden werden.

Ferner wird durch die erfindungsgemäße Prozesschrittabfolge, bei der die Bor-dotierte Rückseitendotierschicht 6 als letzte der amorphen Halbleiterschichten abgeschieden wird, die Ausdiffusion von Bor, welches einen höheren Diffusionskoeffizienten als das in der Vorderseitendotierschicht 5 enthaltene Phosphor aufweist, aus der Rückseitendotierschicht 6 auf ein Minimum beschränkt. Auch hierdurch werden die Solarzelleneigenschaften der auszubildenden Rückseitenemitter-Solarzellenstruktur 1 mit Heteroübergang vorteilhaft beeinflusst.

Wie es in Figur 2 schematisch zu sehen ist, hat die erfindungsgemäße Vorgehensweise auch noch weitere vorteilhafte Effekte. In Figur 2 ist schematisch ein Zwischenprodukt der erfindungsgemäßen Rückseitenemitter-Solarzellenstruktur 1 mit Heteroübergang aus Figur 1i gezeigt. Während in den Figuren 1a bis 1i die sich am Solarzellenrand jeweils bildende Schichtfolgen der Übersichtlichkeit halber weggelassen wurden, ist in Figur 2 diese Schichtfolge nach Abscheidung der amorphen Halbleiterschichten 3, 4, 5 und 6 und vor Ausbildung der weiteren Schichten 7, 8, 9, 10 besonders groß dargestellt.

Ausgehend von dem im dargestellten Ausführungsbeispiel n-dotierten Halbleitersubstrat 2 ergibt sich am Solarzellenrand eine n-i-i-n⁺-p-Schichtfolge. Dagegen ergibt sich im Stand der Technik durch die herkömmliche Verfahrensabfolge eine n-i-n⁺-i-p-Schichtfolge. Die doppelte Intrinsicschicht 3, 4 auf dem Rand bzw. an der Seitenkante des Halbleitersubstrates 2 scheint die ausgebildete Struktur besonders vor einer Ausbildung von Nebenschlusswiderständen und Leckströmen am Solarzellenrand zu schützen.

In den Figuren 3 und 4 sind schematisch Teilbereiche möglicher Anlagenkonzepte bzw. Vorrichtungen 30, 40 für die Herstellung von Rückseitenemitter-Solarzellenstrukturen 1 mit Heteroübergang, wie sie oben beschrieben sind, dargestellt. Die Vorrichtung 30, die in Figur 3 bereichsweise schematisch dargestellt ist, als auch die Vorrichtung 40, die in Figur 4 bereichsweise dargestellt ist, weisen jeweils für die Ausbildung der amorphen Halbleiterschichten 3, 4, 5, 6 drei Schichtabscheidungsstränge 31, 32 bzw. 42, 33 auf.

In einem ersten Schichtabscheidungsstrang 31 ist wenigstens ein Schichtabscheidungsreaktor 36 zum Erzeugen der wenigstens einen Rückseitenintrinsicschicht 3 auf der Rückseite des Halbleitersubstrates 2 vorgesehen.

In einem zweiten Schichtabscheidungsstrang 32 bzw. 42 ist wenigstens ein Schichtabscheidungsreaktor 39, 41; 44 zum Erzeugen der wenigstens einen Vorderseitenintrinsicschicht 4 auf der Vorderseite des Halbleitersubstrates 2 und zum Erzeugen der wenigstens einen Vorderseitendotierschicht 5 auf der wenigstens einen Vorderseitenintrinsicschicht 4 vorgesehen. In der Vorrichtung 40 weist der zweite Schichtabscheidungsstrang 42 nur einen einzigen Vorderseitenschichtabscheidungsreaktor 44 zum Erzeugen der wenigstens einen Vorderseitenintrinsicschicht 4 auf der Vorderseite des Halbleitersubstrates 2 und der wenigstens einen Vorderseitendotierschicht 5 auf der wenigstens einen Vorderseitenintrinsicschicht 4 auf.

In einem dritten Schichtabscheidungsstrang 33 ist wenigstens ein Schichtabscheidungsreaktor 43 zum Erzeugen der wenigstens einen Rückseitendotierschicht 6 auf der wenigstens einen Rückseitenintrinsicschicht 3 vorgesehen.

Zwischen dem ersten Schichtabscheidungsstrang 31 und dem zweiten Schichtabscheidungsstrang 32 bzw. 42 sowie zwischen dem zweiten Schichtabscheidungsstrang 32 bzw. 42 und dem dritten Schichtabscheidungsstrang 33 ist jeweils ein Substrattransport- und -wendesystem 37 vorgesehen. Bei den Vorrichtungen 30, 40 ist nur ein einziges Substrattransport- und -wendesystem 37 vorgesehen, welches sich vor dem/den Vorderseitenschichtabscheidungsreaktor(en) 39, 41 bzw. 44 befindet.

Zwischen und vor den einzelnen Schichtabscheidungsreaktoren ist jeweils eine Schleuseneinrichtung 45 vorgesehen.

Zu Beginn jedes Schichtabscheidungsstranges 31, 32 bzw. 42, 33 ist jeweils eine Be- und Entladeeinrichtung 35 vorgesehen.

## Patentansprüche

1. Verfahren zum Herstellen einer Rückseitenemitter-Solarzellenstruktur (1) mit einem Heteroübergang, wobei
- zur Ausbildung eines Absorbers der Rückseitenemitter-Solarzellenstruktur (1) ein kristallines Halbleitersubstrat (2) mit einer Dotierung eines ersten Leitungstyps bereitgestellt wird;
- auf einer Vorderseite des Halbleitersubstrates (2) wenigstens eine Vorderseitenintrinsicschicht (4) aus einem intrinsischen, amorphen Halbleitermaterial erzeugt wird;
- auf der wenigstens einen Vorderseitenintrinsicschicht (4) wenigstens eine Vorderseitendotierschicht (5) aus einem amorphen Halbleitermaterial mit einer Dotierung des ersten Leitungstyps, die höher als die Dotierung des Halbleitersubstrates (2) ist, erzeugt wird;
- auf einer Rückseite des Halbleitersubstrates (2) wenigstens eine Rückseitenintrinsicschicht (3) aus einem intrinsischen, amorphen Halbleitermaterial erzeugt wird;
- zur Ausbildung eines Emitters der Rückseitenemitter-Solarzellenstruktur (1) mit Heteroübergang auf der wenigstens einen Rückseitenintrinsicschicht (3) wenigstens eine Rückseitendotierschicht (6) aus einem amorphen Halbleitermaterial mit einer Dotierung eines zweiten Leitungstyps, der entgegengesetzt zu dem ersten Leitungstyp ist, erzeugt wird;
- auf der wenigstens einen Vorderseitendotierschicht (5) wenigstens eine elektrisch leitfähige, transparente Vorderseitenleitungsschicht (7) erzeugt wird;
- auf der wenigstens einen Rückseitendotierschicht (6) wenigstens eine elektrisch leitfähige, transparente Rückseitenleitungsschicht (8) erzeugt wird;
- auf der wenigstens einen elektrisch leitfähigen, transparenten Vorderseitenleitungsschicht (7) eine Vorderseitenkontaktierung (9) erzeugt wird; und
- auf der wenigstens einen elektrisch leitfähigen, transparenten Rückseitenleitungsschicht (8) eine Rückseitenkontaktierung (10) erzeugt wird,
**dadurch gekennzeichnet,**
**dass** die Vorder- und Rückseitenintrinsicschichten (3, 4) und die Vorder- und Rückseitendotierschichten (5, 6) in folgender Reihenfolge erzeugt werden:
- Erzeugen der wenigstens einen Rückseitenintrinsicschicht (3) auf der Rückseite des Halbleitersubstrates (2);
- dann Erzeugen der wenigstens einen Vorderseitenintrinsicschicht (4) auf der Vorderseite des Halbleitersubstrates (2);
- dann Erzeugen der wenigstens einen Vorderseitendotierschicht (5) auf der wenigstens einen Vorderseitenintrinsicschicht (4); und
- dann Erzeugen der wenigstens einen Rückseitendotierschicht (6) auf der wenigstens einen Rückseitenintrinsicschicht (3).

2. Verfahren nach Anspruch 1, **dadurch gekennzeichnet, dass** als das Halbleitersubstrat (2) ein n-dotiertes Halbleitersubstrat verwendet wird, für das Erzeugen der Vorderseitendotierschicht (5) ein mit Phosphor dotiertes amorphes Halbleitermaterial verwendet wird und zum Erzeugen der Rückseitendotierschicht (6) ein mit Bor dotiertes amorphes Halbleitermaterial verwendet wird.

3. Verfahren nach Anspruch 1 oder 2, **dadurch gekennzeichnet, dass** das Erzeugen der wenigstens einen Vorderseitenintrinsicschicht (4) auf der Vorderseite des Halbleitersubstrates (2) und das Erzeugen der wenigstens einen Vorderseitendotierschicht (5) auf der wenigstens einen Vorderseitenintrinsicschicht (4) in direkt nacheinander in ein und demselben Schichtabscheidungsreaktor (44) stattfindenden Prozessen vorgenommen werden.

4. Verfahren nach einem der vorhergehenden Ansprüche, **dadurch gekennzeichnet, dass** die wenigstens eine elektrisch leitfähige, transparente Rückseitenleitungsschicht (8) auf der wenigstens einen Rückseitendotierschicht (6) mit einem Abstand zur Seitenkante (50) des Halbleitersubstrates (2) abgeschieden wird, sodass ein Randbereich (51) auf der Rückseite der Rückseitenemitter-Solarzellenstruktur (1) mit Heteroübergang nicht mit der elektrisch leitfähigen, transparenten Rückseitenleitungsschicht (8) beschichtet ist und bei allen Verfahrensschritten zur Ausbildung der elektrisch leitfähigen, transparenten Rückseitenleitungsschicht (8) kein elektrischer Kontakt zwischen der elektrisch leitfähigen, transparenten Rückseitenleitungsschicht (8) und der Vorderseitenleitungsschicht (7) besteht.

5. Rückseitenemitter-Solarzellenstruktur (1) mit einem Heteroübergang, mit
- einem Absorber aus einem kristallinen Halbleitersubstrat (2) mit einer Dotierung eines ersten Leitungstyps;
- wenigstens einer auf einer Vorderseite des Absorbers ausgebildeten Vorderseitenintrinsicschicht (4) aus einem intrinsischen, amorphen Halbleitermaterial;
- wenigstens einer auf einer Rückseite des Absorbers ausgebildeten Rückseitenintrinsicschicht (3) aus einem intrinsischen, amorphen Halbleitermaterial;
- wenigstens einer auf der wenigstens einen Vorderseitenintrinsicschicht 84) ausgebildeten Vorderseitendotierschicht (5) aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht (3) ausgebildeten Rückseitendotierschicht (6) aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht (5) ausgebildeten elektrisch leitfähigen, transparenten Vorderseitenleitungsschicht (7);
- wenigstens einer auf der wenigstens einen Rückseitendotierschicht (6) ausgebildeten elektrisch leitfähigen, transparenten Rückseitenleitungsschicht (8);
- einer auf der wenigstens einen elektrisch leitfähigen, transparenten Vorderseitenleitungsschicht (7) ausgebildeten Vorderseitenkontaktierung (9), und
- einer auf der wenigstens einen elektrisch leitfähigen, transparenten Rückseitenleitungsschicht (8) ausgebildeten Rückseitenkontaktierung (10);
**dadurch gekennzeichnet,**
**dass** an einem Seitenrand (50) der Rückseitenemitter-Solarzellenstruktur (1) mit Heteroübergang auf einem Randbereich des Halbleitersubstrates (2) eine Schichtfolge in folgender Reihenfolge von innen nach außen vorliegt:
- die wenigstens eine Rückseitenintrinsicschicht (3),
- darauf die wenigstens eine Vorderseitenintrinsicschicht (4),
- darauf die wenigstens eine Vorderseitendotierschicht (5) und
- darauf die wenigstens eine Rückseitendotierschicht (6).

6. Rückseitenemitter-Solarzellenstruktur mit Heteroübergang nach Anspruch 5, **dadurch gekennzeichnet, dass** das Halbleitersubstrat (2) ein n-dotiertes Halbleitersubstrat ist, die Vorderseitendotierschicht (5) mit Phosphor dotiert ist und die Rückseitendotierschicht (6) mit Bor dotiert ist.

7. Rückseitenemitter-Solarzellenstruktur (1) mit Heteroübergang nach Anspruch 5 oder 6, **dadurch gekennzeichnet, dass** die wenigstens eine elektrisch leitfähige, transparente Rückseitenleitungsschicht (8) auf der wenigstens einen Rückseitendotierschicht (6) mit einem Abstand zur Seitenkante (50) des Halbleitersubstrates (2) abgeschieden ist, sodass ein Randbereich (51) auf der Rückseite der Rückseitenemitter-Solarzellenstruktur (1) mit Heteroübergang nicht mit der elektrisch leitfähigen, transparenten Rückseitenleitungsschicht (8) beschichtet ist und kein elektrischer Kontakt zwischen der elektrisch leitfähigen, transparenten Rückseitenleitungsschicht (8) und der Vorderseitenleitungsschicht (7) besteht.

8. Vorrichtung (30, 40) zur Herstellung einer Rückseitenemitter-Solarzellenstruktur (1) mit einem Heteroübergang, mit
- einem Absorber aus einem kristallinen Halbleitersubstrat (2) mit einer Dotierung eines ersten Leitungstyps;
- wenigstens einer auf einer Vorderseite des Absorbers ausgebildeten Vorderseitenintrinsicschicht (4) aus einem intrinsischen, amorphen Halbleitermaterial;
- wenigstens einer auf einer Rückseite des Absorbers ausgebildeten Rückseitenintrinsicschicht (3) aus einem intrinsischen, amorphen Halbleitermaterial;
- wenigstens einer auf der wenigstens einen Vorderseitenintrinsicschicht (4) ausgebildeten Vorderseitendotierschicht (5) aus einem amorphen Halbleitermaterial mit einer Dotierung des ersten Leitungstyps, die höher als die Dotierung des Absorbers ist;
- einem Emitter aus wenigstens einer auf der wenigstens einen Rückseitenintrinsicschicht (3) ausgebildeten Rückseitendotierschicht (6) aus einem amorphen Halbleitermaterial mit einer Dotierung eines zweiten Leitungstyps, der entgegengesetzt zu dem ersten Leitungstyp ist;
- wenigstens einer auf der wenigstens einen Vorderseitendotierschicht (5) ausgebildeten elektrisch leitfähigen, transparenten Vorderseitenleitungsschicht (7);
- wenigstens einer auf der wenigstens einen Rückseitendotierschicht (6) ausgebildeten elektrisch leitfähigen, transparenten Rückseitenleitungsschicht (8);
- einer auf der wenigstens einen Vorderseitenleitungsschicht (7) ausgebildeten Vorderseitenkontaktierung (9); und
- einer auf der wenigstens einen Rückseitenleitungsschicht (8) ausgebildeten Rückseitenkontaktierung (10);
**dadurch gekennzeichnet,**
**dass** die Vorrichtung (30, 40) zum Erzeugen der wenigstens einen Vorderseitenintrinsicschicht (4) auf der Vorderseite des Halbleitersubstrates (2), der wenigstens einen Rückseitenintrinsicschicht (3) auf der Rückseite des Halbleitersubstrates (2), der wenigstens einen Vorderseitendotierschicht (5) auf der wenigstens einen Vorderseitenintrinsicschicht (4) und der wenigstens einen Rückseitendotierschicht (6) auf der wenigstens einen Rückseitenintrinsicschicht (3) nur drei Schichtabscheidungsstränge (31; 32 bzw. 42; 33) aufweist, wobei
- ein erster Schichtabscheidungsstrang (31) wenigstens einen Schichtabscheidungsreaktor (36) zum Erzeugen der wenigstens einen Rückseitenintrinsicschicht (3) auf der Rückseite des Halbleitersubstrates (2) aufweist;
- ein zweiter Schichtabscheidungsstrang (32 bzw. 42) wenigstens einen Schichtabscheidungsreaktor (39, 41 bzw. 44) zum Erzeugen der wenigstens einen Vorderseitenintrinsicschicht (4) auf der Vorderseite des Halbleitersubstrates (2) und zum Erzeugen der wenigstens einen Vorderseitendotierschicht (5) auf der wenigstens einen Vorderseitenintrinsicschicht (4) aufweist; und
- ein dritter Schichtabscheidungsstrang (33) wenigstens einen Schichtabscheidungsreaktor (43) zum Erzeugen der wenigstens einen Rückseitendotierschicht (6) auf der wenigstens einen Rückseitenintrinsicschicht (3) aufweist;
und wobei zwischen dem ersten und dem zweiten Schichtabscheidungsstrang (31, 32 bzw. 42) und zwischen dem zweiten und dem dritten Schichtabscheidungsstrang (32 bzw. 42, 33) wenigstens ein Substrattransport- und -wendesystem (37) vorgesehen ist.

9. Vorrichtung nach Anspruch 8, **dadurch gekennzeichnet, dass** der erste Schichtabscheidungsstrang (31) einen Rückseitenintrinsicschichtabscheidungsreaktor (36) zum Erzeugen der wenigstens einen Rückseitenintrinsicschicht (3) auf der Rückseite des Halbleitersubstrates (2) aufweist; der zweite Schichtabscheidungsstrang (42) einen einzigen Vorderseitenschichtabscheidungsreaktor (44) zum Erzeugen der wenigstens einen Vorderseitenintrinsicschicht (4) auf der Vorderseite des Halbleitersubstrates (2) und der wenigstens einen Vorderseitendotierschicht (5) auf der wenigstens einen Vorderseitenintrinsicschicht (4) aufweist; und der dritte Schichtabscheidungsstrang (33) einen Rückseitendotierschichtabscheidungsreaktor (43) zum Erzeugen der wenigstens einen Rückseitendotierschicht (6) auf der wenigstens einen Rückseitenintrinsicschicht (3) aufweist; und das wenigstens eine Substrattransport- und -wendesystem (37) vor dem Vorderseitenschichtabscheidungsreaktor (44) vor oder in dem zweiten Schichtabscheidungsstrang (42) vorgesehen ist.

## Claims

1. Method for producing a rear emitter solar cell structure (1) having a heterojunction, wherein
- to form an absorber of the rear emitter solar cell structure (1), a crystalline semiconductor substrate (2) having a doping of a first conductivity type is provided;
- on a front side of the semiconductor substrate (2) at least one front intrinsic layer (4) is produced from an intrinsic, amorphous semiconductor material;
- on the at least one front intrinsic layer (4) at least one front doping layer (5) is produced from an amorphous semiconductor material having a doping of the first conductivity type, which is higher than the doping of the semiconductor substrate (2);
- on a rear side of the semiconductor substrate (2) at least one rear intrinsic layer (3) is produced from an intrinsic, amorphous semiconductor material;
- to form an emitter of the rear emitter solar cell structure (1) having a heterojunction, on the at least one rear intrinsic layer (3), at least one rear doping layer (6) is produced from an amorphous semiconductor material having a doping of a second conductivity type, which is opposite to the first conductivity type;
- at least one electrically conductive, transparent front conduction layer (7) is produced on the at least one front doping layer (5);
- at least one electrically conductive, transparent rear conduction layer (8) is produced on the at least one rear doping layer (6);
- a front contact (9) is produced on the at least one electrically conductive, transparent front conduction layer (7); and
- a rear contact (10) is produced on the at least one electrically conductive, transparent rear conduction layer (8),
**characterized in that**
the front and rear intrinsic layers (3, 4) and the front and rear doping layers (5, 6) are produced in the following order of steps:
- producing the at least one rear intrinsic layer (3) on the rear side of the semiconductor substrate (2);
- then producing the at least one front intrinsic layer (4) on the front side of the semiconductor substrate (2);
- then producing the at least one front doping layer (5) on the at least one front intrinsic layer (4); and
- then producing the at least one rear doping layer (6) on the at least one rear intrinsic layer (3).

2. Method according to claim 1, **characterized in that** an n-doped semiconductor substrate is used as the semiconductor substrate (2), an amorphous semiconductor material doped with phosphorus is used for producing the front doping layer (5), and an amorphous semiconductor material doped with boron is used for producing the rear doping layer (6).

3. Method according to either claim 1 or claim 2, **characterized in that** the at least one front intrinsic layer (4) is produced on the front side of the semiconductor substrate (2) and the at least one front doping layer (5) is produced on the at least one front intrinsic layer (4) in processes taking place one directly after another in the same layer deposition reactor (44).

4. Method according to any of the preceding claims, **characterized in that** the at least one electrically conductive, transparent rear conduction layer (8) is deposited on the at least one rear doping layer (6) at a distance from the side edge (50) of the semiconductor substrate (2), so that an edge region (51) on the rear side of the rear emitter solar cell structure (1) having a heterojunction is not coated with the electrically conductive, transparent rear conduction layer (8) and, in all method steps for forming the electrically conductive, transparent rear conduction layer (8), there is no electrical contact between the electrically conductive, transparent rear conduction layer (8) and the front conduction layer (7).

5. Rear emitter solar cell structure (1) having a heterojunction, having
- an absorber made of a crystalline semiconductor substrate (2) having a doping of a first conductivity type;
- at least one front intrinsic layer (4) formed on a front side of the absorber and made of an intrinsic, amorphous semiconductor material;
- at least one rear intrinsic layer (3) formed on a rear side of the absorber and made of an intrinsic, amorphous semiconductor material;
- at least one front doping layer (5) formed on the at least one front intrinsic layer 84) and made of an amorphous semiconductor material having a doping of the first conductivity type, which is higher than the doping of the absorber;
- an emitter of at least one rear doping layer (6) formed on the at least one rear intrinsic layer (3) and made of an amorphous semiconductor material having a doping of a second conductivity type, which is opposite to the first conductivity type;
- at least one electrically conductive, transparent front conduction layer (7) formed on the at least one front doping layer (5);
- at least one electrically conductive, transparent rear conduction layer (8) formed on the at least one rear doping layer (6);
- a front contact (9) formed on the at least one electrically conductive, transparent front conduction layer (7), and
- a rear contact (10) formed on the at least one electrically conductive, transparent rear conduction layer (8);
**characterized in that**
on one side edge (50) of the rear emitter solar cell structure (1) having a heterojunction, on an edge region of the semiconductor substrate (2), there is a layer sequence in the following order from the inside to the outside:
- the at least one rear intrinsic layer (3),
- thereupon the at least one front intrinsic layer (4),
- thereupon the at least one front doping layer (5) and
- thereupon the at least one rear doping layer (6).

6. Rear emitter solar cell structure having a heterojunction according to claim 5, **characterized in that** the semiconductor substrate (2) is an n-doped semiconductor substrate, the front doping layer (5) is doped with phosphorus and the rear doping layer (6) is doped with boron.

7. Rear emitter solar cell structure (1) having a heterojunction according to either claim 5 or claim 6, **characterized in that** the at least one electrically conductive, transparent rear conduction layer (8) is deposited on the at least one rear doping layer (6) at a distance from the side edge (50) of the semiconductor substrate (2), so that an edge region (51) on the rear side of the rear emitter solar cell structure (1) having a heterojunction is not coated with the electrically conductive, transparent rear conduction layer (8) and there is no electrical contact between the electrically conductive, transparent rear conduction layer (8) and the front conduction layer (7).

8. Device (30, 40) for producing a rear emitter solar cell structure (1) having a heterojunction, having
- an absorber made of a crystalline semiconductor substrate (2) having a doping of a first conductivity type;
- at least one front intrinsic layer (4) formed on a front side of the absorber and made of an intrinsic, amorphous semiconductor material;
- at least one rear intrinsic layer (3) formed on a rear side of the absorber and made of an intrinsic, amorphous semiconductor material;
- at least one front doping layer (5) formed on the at least one front intrinsic layer (4) and made of an amorphous semiconductor material having a doping of the first conductivity type, which is higher than the doping of the absorber;
- an emitter of at least one rear doping layer (6) formed on the at least one rear intrinsic layer (3) and made of an amorphous semiconductor material having a doping of a second conductivity type, which is opposite to the first conductivity type;
- at least one electrically conductive, transparent front conduction layer (7) formed on the at least one front doping layer (5);
- at least one electrically conductive, transparent rear conduction layer (8) formed on the at least one rear doping layer (6);
- a front contact (9) formed on the at least one front conduction layer (7); and
- a rear contact (10) formed on the at least one rear conduction layer (8);
**characterized in that**
the device (30, 40) for producing the at least one front intrinsic layer (4) on the front side of the semiconductor substrate (2), the at least one rear intrinsic layer (3) on the rear side of the semiconductor substrate (2), the at least one front doping layer (5) on the at least one front intrinsic layer (4) and the at least one rear doping layer (6) on the at least one rear intrinsic layer (3) has only three layer deposition strands (31; 32 or 42; 33), wherein
- a first layer deposition strand (31) has at least one layer deposition reactor (36) for producing the at least one rear intrinsic layer (3) on the rear side of the semiconductor substrate (2);
- a second layer deposition strand (32 or 42) has at least one layer deposition reactor (39 and 41 or 44) for producing the at least one front intrinsic layer (4) on the front side of the semiconductor substrate (2) and for producing the at least one front doping layer (5) on the at least one front intrinsic layer (4); and
- a third layer deposition strand (33) has at least one layer deposition reactor (43) for producing the at least one rear doping layer (6) on the at least one rear intrinsic layer (3);
- and wherein at least one substrate transport and turning system (37) is provided between the first and the second layer deposition strand (31 and 32 or 42) and between the second and the third layer deposition strand (32 or 42 and 33).

9. Device according to claim 8, **characterized in that** the first layer deposition strand (31) has a rear intrinsic layer deposition reactor (36) for producing the at least one rear intrinsic layer (3) on the rear side of the semiconductor substrate (2); the second layer deposition strand (42) has a single front layer deposition reactor (44) for producing the at least one front intrinsic layer (4) on the front side of the semiconductor substrate (2) and the at least one front doping layer (5) on the at least one front intrinsic layer (4); and the third layer deposition strand (33) has a rear doping layer deposition reactor (43) for producing the at least one rear doping layer (6) on the at least one rear intrinsic layer (3); and the at least one substrate transport and turning system (37) is provided upstream of the front layer deposition reactor (44) before or in the second layer deposition strand (42).

## Revendications

1. Procédé de fabrication d'une structure de cellule solaire à émetteur arrière (1) ayant une hétérojonction, dans lequel
- un substrat semi-conducteur (2) cristallin ayant un dopage d'un premier type de conductivité est fourni pour la formation d'un absorbeur de la structure de cellule solaire à émetteur arrière (1);
- au moins une couche intrinsèque de face avant (4) est générée sur une face avant du substrat semi-conducteur (2) à partir d'un matériau semi-conducteur amorphe intrinsèque;
- au moins une couche dopante de face avant (5) est générée sur l'au moins une couche intrinsèque de face avant (4) à partir d'un matériau semi-conducteur amorphe ayant un dopage du premier type de conductivité, lequel est supérieur au dopage du substrat semi-conducteur (2);
- au moins une couche intrinsèque de face arrière (3) est générée sur une face arrière du substrat semi-conducteur (2) à partir d'un matériau semi-conducteur amorphe intrinsèque;
- au moins une couche dopante de face arrière (6) est générée sur l'au moins une couche intrinsèque de face arrière (3) à partir d'un matériau semi-conducteur amorphe ayant un dopage d'un deuxième type de conductivité, lequel est opposé au premier type de conductivité, pour la formation d'un émetteur de la structure de cellule solaire à émetteur arrière (1) ayant une hétérojonction;
- au moins une couche conductrice de face avant (7) transparente électriquement conductrice est générée sur l'au moins une couche dopante de face avant (5);
- au moins une couche conductrice de face arrière (8) transparente électriquement conductrice est générée sur l'au moins une couche dopante de face arrière (6);
- un contact électrique de face avant (9) est généré sur l'au moins une couche conductrice de face avant (7) transparente électriquement conductrice; et
- un contact électrique de face arrière (10) est généré sur l'au moins une couche conductrice de face arrière (8) transparente électriquement conductrice,
**caractérisé en ce**
**que** les couches intrinsèques de face avant et arrière (3, 4) et les couches dopantes de face avant et arrière (5, 6) sont générées dans l'ordre suivant:
- génération de l'au moins une couche intrinsèque de face arrière (3) sur la face arrière du substrat semi-conducteur (2);
- ensuite génération de l'au moins une couche intrinsèque de face avant (4) sur la face avant du substrat semi-conducteur (2);
- ensuite génération de l'au moins une couche dopante de face avant (5) sur l'au moins une couche intrinsèque de face avant (4); et
- ensuite génération de l'au moins une couche dopante de face arrière (6) sur l'au moins une couche intrinsèque de face arrière (3).

2. Procédé selon la revendication 1, **caractérisé en ce qu'**un substrat semi-conducteur à dopage n est utilisé comme le substrat semi-conducteur (2), qu'un matériau semi-conducteur amorphe dopé avec du phosphore est utilisé pour la génération de la couche dopante de face avant (5) et qu'un matériau semi-conducteur amorphe dopé avec du bore est utilisé pour la génération de la couche dopante de face arrière (6).

3. Procédé selon la revendication 1 ou 2, **caractérisé en ce que** la génération de l'au moins une couche intrinsèque de face avant (4) sur la face avant du substrat semi-conducteur (2) et la génération de l'au moins une couche dopante de face avant (5) sur l'au moins une couche intrinsèque de face avant (4) sont effectuées directement l'une après l'autre dans des processus ayant lieu dans un seul et même réacteur de dépôt de couches (44).

4. Procédé selon l'une quelconque des revendications précédentes, **caractérisé en ce que** l'au moins une couche conductrice de face arrière (8) transparente électriquement conductrice est déposée sur l'au moins une couche dopante de face arrière (6) à une distance de l'arête latérale (50) du substrat semi-conducteur (2), de telle sorte qu'une zone de bord (51) sur la face arrière de la structure de cellule solaire à émetteur arrière (1) ayant une hétérojonction ne soit pas revêtue de la couche conductrice de face arrière (8) transparente électriquement conductrice et que durant toutes les étapes de procédé pour la formation de la couche conductrice de face arrière (8) transparente électriquement conductrice aucun contact électrique n'existe entre la couche conductrice de face arrière (8) transparente électriquement conductrice et la couche conductrice de face avant (7).

5. Structure de cellule solaire à émetteur arrière (1) ayant une hétérojonction, comprenant
- un absorbeur composé d'un substrat semi-conducteur (2) cristallin ayant un dopage d'un premier type de conductivité;
- au moins une couche intrinsèque de face avant (4) formée sur une face avant de l'absorbeur à partir d'un matériau semi-conducteur amorphe intrinsèque;
- au moins une couche intrinsèque de face arrière (3) formée sur une face arrière de l'absorbeur à partir d'un matériau semi-conducteur amorphe intrinsèque;
- au moins une couche dopante de face avant (5) formée sur l'au moins une couche intrinsèque de face avant 84) à partir d'un matériau semi-conducteur amorphe ayant un dopage du premier type de conductivité, lequel est supérieur au dopage de l'absorbeur;
- un émetteur composé d'au moins une couche dopante de face arrière (6) formée sur l'au moins une couche intrinsèque de face arrière (3) à partir d'un matériau semi-conducteur amorphe ayant un dopage d'un deuxième type de conductivité, lequel est opposé au premier type de conductivité;
- au moins une couche conductrice de face avant (7) transparente électriquement conductrice formée sur l'au moins une couche dopante de face avant (5);
- au moins une couche conductrice de face arrière (8) transparente électriquement conductrice formée sur l'au moins une couche dopante de face arrière (6);
- un contact électrique de face avant (9) formé sur l'au moins une couche conductrice de face avant (7) transparente électriquement conductrice; et
- un contact électrique de face arrière (10) formé sur l'au moins une couche conductrice de face arrière (8) transparente électriquement conductrice;
**caractérisée en ce**
**que** sur une zone de bord du substrat semi-conducteur (2) dans un bord latéral (50) de la structure de cellule solaire à émetteur arrière (1) ayant une hétérojonction, se trouve une séquence de couches dans l'ordre suivant de l'intérieur vers l'extérieur :
- l'au moins une couche intrinsèque de face arrière (3),
- sur celle-ci l'au moins une couche intrinsèque de face avant (4),
- sur celle-ci l'au moins une couche dopante de face avant (5) et
- sur celle-ci l'au moins une couche dopante de face arrière (6).

6. Structure de cellule solaire à émetteur arrière ayant une hétérojonction selon la revendication 5, **caractérisée en ce que** le substrat semi-conducteur (2) est un substrat semi-conducteur à dopage n, la couche dopante de face avant (5) est dopée avec du phosphore et la couche dopante de face arrière (6) est dopée avec du bore.

7. Structure de cellule solaire à émetteur arrière (1) ayant une hétérojonction selon la revendication 5 ou 6, **caractérisée en ce que** l'au moins une couche conductrice de face arrière (8) transparente électriquement conductrice est déposée sur l'au moins une couche dopante de face arrière (6) à une distance de l'arête latérale (50) du substrat semi-conducteur (2), de telle sorte qu'une zone de bord (51) sur la face arrière de la structure de cellule solaire à émetteur arrière (1) ayant une hétérojonction ne soit pas revêtue de la couche conductrice de face arrière (8) transparente électriquement conductrice et qu'aucun contact électrique n'existe entre la couche conductrice de face arrière (8) transparente électriquement conductrice et la couche conductrice de face avant (7).

8. Dispositif (30, 40) pour la fabrication d'une structure de cellule solaire à émetteur arrière (1) ayant une hétérojonction, comprenant
- un absorbeur composé d'un substrat semi-conducteur (2) cristallin ayant un dopage d'un premier type de conductivité;
- au moins une couche intrinsèque de face avant (4) formée sur une face avant de l'absorbeur à partir d'un matériau semi-conducteur amorphe intrinsèque;
- au moins une couche intrinsèque de face arrière (3) formée sur une face arrière de l'absorbeur à partir d'un matériau semi-conducteur amorphe intrinsèque;
- au moins une couche dopante de face avant (5) formée sur l'au moins une couche intrinsèque de face avant (4) à partir d'un matériau semi-conducteur amorphe ayant un dopage du premier type de conductivité, lequel est supérieur au dopage de l'absorbeur;
- un émetteur composé d'au moins une couche dopante de face arrière (6) formée sur l'au moins une couche intrinsèque de face arrière (3) à partir d'un matériau semi-conducteur amorphe ayant un dopage d'un deuxième type de conductivité, lequel est opposé au premier type de conductivité;
- au moins une couche conductrice de face avant (7) transparente électriquement conductrice formée sur l'au moins une couche dopante de face avant (5);
- au moins une couche conductrice de face arrière (8) transparente électriquement conductrice formée sur l'au moins une couche dopante de face arrière (6);
- un contact électrique de face avant (9) formé sur l'au moins une couche conductrice de face avant (7); et
- un contact électrique de face arrière (10) formé sur l'au moins une couche conductrice de face arrière (8);
**caractérisé en ce**
**que** le dispositif (30, 40) ne présente, pour la génération de l'au moins une couche intrinsèque de face avant (4) sur la face avant du substrat semi-conducteur (2), de l'au moins une couche intrinsèque de face arrière (3) sur la face arrière du substrat semi-conducteur (2), de l'au moins une couche dopante de face avant (5) sur l'au moins une couche intrinsèque de face avant (4) et de l'au moins une couche dopante de face arrière (6) sur l'au moins une couche intrinsèque de face arrière (3), que trois tubes de dépôt de couche (31, 32 ou 42 ; 33), dans lequel
- un premier tube de dépôt de couche (31) présente au moins un réacteur de dépôt de couche (36) pour la génération de l'au moins une couche intrinsèque de face arrière (3) sur la face arrière du substrat semi-conducteur (2);
- un deuxième tube de dépôt de couche (32 ou 42) présente au moins un réacteur de dépôt de couche (39, 41 ou 44) pour la génération de l'au moins une couche intrinsèque de face avant (4) sur la face avant du substrat semi-conducteur (2) et pour la génération de l'au moins une couche dopante de face avant (5) sur l'au moins une couche intrinsèque de face avant (4); et
- un troisième tube de dépôt de couche (33) présente au moins un réacteur de dépôt de couche (43) pour la génération de l'au moins une couche dopante de face arrière (6) sur l'au moins une couche intrinsèque de face arrière (3);
et au moins un système de transport et de retournement de substrat (37) étant prévu entre le premier et le deuxième tube de dépôt de couche (31, 32 ou 42) et entre le deuxième et le troisième tube de dépôt de couche (32 ou 42, 33).

9. Dispositif selon la revendication 8, **caractérisé en ce que** le premier tube de dépôt de couche (31) présente un réacteur de dépôt de couche intrinsèque de face arrière (36) pour la génération de l'au moins une couche intrinsèque de face arrière (3) sur la face arrière du substrat semi-conducteur (2) ; le deuxième tube de dépôt de couche (42) présente un seul réacteur de dépôt de couche de face avant (44) pour la génération de l'au moins une couche intrinsèque de face avant (4) sur la face avant du substrat semi-conducteur (2) et de l'au moins une couche dopante de face avant (5) sur l'au moins une couche intrinsèque de face avant (4) ; et le troisième tube de dépôt de couche (33) présente un réacteur de dépôt de couche dopante de face arrière (43) pour la génération de l'au moins une couche dopante de face arrière (6) sur l'au moins une couche intrinsèque de face arrière (3) ; et l'au moins un système de transport et retournement de substrat (37) est prévu devant le réacteur de dépôt de couche de face avant (44), devant ou dans le deuxième tube de dépôt de couche (42).
